# EUROPEAN PATENT SPECIFICATION

(11) **EP 3 301 727 B1**
(45) Date of publication and mention of the grant of the patent: **26.04.2023**
(21) Application number: 16197828.3
(22) Date of filing: 08.11.2016
(51) Int. Cl.: H01L 31/0687, H01L 31/078, H01L 31/05, H01L 31/0304

(54) **LATTICE MATCHED MULTIJUNCTION SOLAR CELL ASSEMBLIES FOR SPACE APPLICATIONS AND MANUFACTURING METHOD THEREFOR**
GITTERANGEPASSTE MEHRFACHSOLARZELLENANORDNUNGEN FÜR RAUMFAHRTANWENDUNGEN UND HERSTELLUNGSVERFAHREN DAFÜR
ENSEMBLES DE CELLULES SOLAIRES À JONCTIONS MULTIPLES ADAPTÉES EN RÉSEAU POUR APPLICATIONS SPATIALES ET MÉTHODE DE FABRICATION ASSOCIÉE

(30) Priority: 03.10.2016 US 201615283598
(43) Date of publication of application: 04.04.2018
(73) Proprietor: SolAero Technologies Corp., Albuquerque, NM 87123 (US)
(72) Inventor: DERKACS, Daniel, Albuquerque, NM 87111 (US)
(74) Representative: adares Patent- und Rechtsanwälte Reininger & Partner GmbB

(56) References cited:
- EP-A1- 3 159 940
- EP-A2- 0 848 433
- US-A1- 2006 144 435
- US-A1- 2006 162 768
- US-A1- 2010 147 366
- US-A1- 2011 011 983
- US-A1- 2012 042 937
- US-A1- 2014 261 628
- FRAAS L ET AL: "AM0 calibration of 34% efficient mechanically stacked GaInP/GaAsGaSb circuits", CONFERENCE RECORD OF THE IEEE PHOTOVOLTAIC SPECIALISTS CONFERENCE 2002, vol. CONF. 29, 19 May 2002 (2002-05-19), pages 912-915, XP010666430, DOI: 10.1109/PVSC.2002.1190728 ISBN: 978-0-7803-7471-3
- R. R. KING ET AL: "Group-IV Subcells in Multijunction Concentrator Solar Cells", ECS TRANSACTIONS, vol. 50, no. 9, 15 March 2013 (2013-03-15) , pages 287-295, XP055135598, ISSN: 1938-6737, DOI: 10.1149/05009.0287ecst
- Daniel J. Aiken: "InGaP/GaAs/Ge multi-junction solar cell efficiency improvements using epitaxial germanium", Proceedings of 28th IEEE Photovoltaic Specialists Conference - 15-22 Sept. 2000 - Anchorage, AK, USA, 15 September 2000 (2000-09-15), pages 994-997, XP055614171, PISCATAWAY, NJ [US] DOI: 10.1109/PVSC.2000.916053 ISBN: 978-0-7803-5772-3
- David B. Jackrel ET AL: "Dilute nitride GaInNAs and GaInNAsSb solar cells by molecular beam epitaxy", Journal of Applied Physics, vol. 101, no. 11, 1 June 2007 (2007-06-01) , page 114916, XP055557863, US ISSN: 0021-8979, DOI: 10.1063/1.2744490
- Matthew P. Lumb ET AL: "Realizing the next generation of CPV cells using transfer printing", AIP CONFERENCE PROCEEDINGS, vol. 1679, 1 January 2015 (2015-01-01), pages 040007-1, XP055528047, NEW YORK, US ISSN: 0094-243X, DOI: 10.1063/1.4931518

## Description

### BACKGROUND OF THE INVENTION

### Field of the Invention

The present disclosure relates to solar cells and the fabrication of solar cells, and more particularly the design and specification of a multijunction solar cell using electrically coupled but spatially separated semiconductor regions in a semiconductor body based on III-V semiconductor compounds.

### Description of the Related Art

Solar power from photovoltaic cells, also called solar cells, has been predominantly provided by silicon semiconductor technology. In the past several years, however, high-volume manufacturing of III-V compound semiconductor multijunction solar cells for space applications has accelerated the development of such technology not only for use in space but also for terrestrial solar power applications. Compared to silicon, III-V compound semiconductor multijunction devices have greater energy conversion efficiencies and generally more radiation resistance, although they tend to be more complex to properly specify and manufacture. Typical commercial III-V compound semiconductor multijunction solar cells have energy efficiencies that exceed 27% under one sun, air mass 0 (AM0) illumination, whereas even the most efficient silicon technologies generally reach only about 18% efficiency under comparable conditions. The higher conversion efficiency of III-V compound semiconductor solar cells compared to silicon solar cells is in part based on the ability to achieve spectral splitting of the incident radiation through the use of a plurality of photovoltaic regions with different band gap energies, and accumulating the current from each of the regions.

In satellite and other space related applications, the size, mass and cost of a satellite power system are dependent on the power and energy conversion efficiency of the solar cells used. Putting it another way, the size of the payload and the availability of on-board services are proportional to the amount of power provided. Thus, as payloads become more sophisticated, and applications anticipated for five, ten, twenty or more years, the power-to-weight ratio and lifetime efficiency of a solar cell becomes increasingly more important, and there is increasing interest not only the amount of power provided at initial deployment, but over the entire service life of the satellite system, or in terms of a design specification, the amount of power provided at the "end of life" (EOL).

The efficiency of energy conversion, which converts solar energy (or photons) to electrical energy, depends on various factors such as the design of solar cell structures, the choice of semiconductor materials, and the thickness of each subcell. In short, the energy conversion efficiency for each solar cell is dependent on the optimum utilization of the available sunlight across the solar spectrum as well as the "age" of the solar cell, i.e. the length of time it has been deployed and subject to degradation associated with the temperature and radiation in the deployed space environment. As such, the characteristic of sunlight absorption in semiconductor material, also known as photovoltaic properties, is critical to determine the most efficient semiconductor to achieve the optimum energy conversion to meet customer requirements of intended orbit and lifetime.

Typical III-V compound semiconductor solar cells are fabricated on a semiconductor wafer in vertical, multijunction structures or stacked sequence of solar subcells, each subcell formed with appropriate semiconductor layers and including a p-n photoactive junction. Each subcell is designed to convert photons over different spectral or wavelength bands to electrical current. After the sunlight impinges on the front of the solar cell, and photons pass through the subcells, the photons in a wavelength band that are not absorbed and converted to electrical energy in the region of one subcell propagate to the next subcell, where such photons are intended to be captured and converted to electrical energy, assuming the downstream subcell is designed for the photon's particular wavelength or energy band.

The individual solar cells or wafers are then disposed in horizontal arrays or panels, with the individual solar cells connected together in an electrical series and/or parallel circuit. The shape and structure of an array, as well as the number of cells it contains, are determined in part by the desired output voltage and current.

The energy conversion efficiency of multijunction solar cells is affected by such factors as the number of subcells, the thickness of each subcell, the composition and doping of each active layer in a subcell, and the consequential band structure, electron energy levels, conduction, and absorption of each subcell, as well as its exposure to radiation in the ambient environment over time. Factors such as the short circuit current density (J_{sc}), the open circuit voltage (V_{oc}), and the fill factor are thereby affected and are also important. Another parameter of consideration taught by the present disclosure is the difference between the band gap and the open circuit voltage, or (E_{g}/q - V_{oc}), of a particular active layer, and such parameters may vary depending on subcell layer thicknesses, doping, the composition of adjacent layers (such as tunnel diodes), and even the specific wafer being examined from a set of wafers processed on a single supporting platter in a reactor run. Such factors also over time (i.e. during the operational life of the system). Accordingly, such parameters are NOT simple "result effective" variables (as discussed and emphasized below) to those skilled in the art confronted with complex design specifications and practical operational considerations.

One of the important mechanical or structural considerations in the choice of semiconductor layers for a solar cell is the desirability of the adjacent layers of semiconductor materials in the solar cell, i.e. each layer of crystalline semiconductor material that is deposited and grown to form a solar subcell, have similar crystal lattice constants or parameters. The present application is directed to solar cells with several substantially lattice matched subcells, and in a particular embodiment to a five junction (5J) solar cell using electrically coupled but spatially separated four junction (4J) semiconductor devices in a single semiconductor body.

US 2006/162768 A1 describes a multijunction solar cell having a substrate, three spatially separate regions above the substrate, each having three subcells, and six spatially separate regions below the substrate, each having two subcells. The contact layers form interconnections between all these subcells. US 2006/162768 A1 does not disclose a four junction solar cell made through interconnecting subcells of only two distinct, electrically isolated spatially separated semiconductor regions.

US 2006/144435 A1 describes a monolithic, multi-bandgap, tandem solar photovoltaic converter having at least one, and preferably at least two, subcells grown lattice-matched on a substrate with a bandgap in medium to high energy portions of the solar spectrum and at least one subcell grown lattice-mismatched to the substrate with a bandgap in the low energy portion of the solar spectrum, for example, about 1 eV.

US 2014/261628 A1 discloses a solar receiver including at least two electrically independent photovoltaic cells which are stacked. An inter-cell interface between the photovoltaic cells includes a multi-layer dielectric stack. The multi-layer dielectric stack includes at least two dielectric layers having different refractive indices.

FRAAS L ET AL: "AM0 calibration of 34% efficient mechanically stacked GaInP/GaAs-GaSb circuits", CONFERENCE RECORD OF THE IEEE PHOTOVOLTAIC SPECIALISTS CONFERENCE 2002, 19 May 2002, pages 912-915, describe that during a recent NASA Phase 2 SBIR contract JX Crystals fabricated a batch of triple-junction voltage-matched line-focus concentrator cell circuits, which measured up to 3.4 watts of output power, over 30% AM0 efficiency, during initial flash testing. These circuits have 4 GaInP/GaAs dual junction cells on transparent GaAs assembled on top of 8 diffused junction GaSb booster cells.

US 2012/042937 A1 describes a multiple junction solar cell comprising at least one partitioned junction, each partition of the partitioned junction having substantially the same current and each junction having substantially the same current.

EP 0 848 433 A2 discloses a two-terminal voltage or current matched solar cell having up to four photovoltaically active junctions which efficiently convert solar radiation into electricity. The solar cell comprises GaInP, GaAs, and GaInAsP, and in the four junction case, GaInAs is used as well.

US 2010/147366 A1 describes a multijunction solar cell including an upper first solar subcell having a first band gap; a middle second solar subcell adjacent to the first solar subcell and having a second band gap smaller than the first band gap, and having a base layer and an emitter layer, a graded interlayer adjacent to the second solar subcell; the graded interlayer having a third band gap greater than the second band gap; a third solar subcell adjacent to the interlayer, the third subcell having a fourth band gap smaller than the second band gap such that the third subcell is lattice mismatched with respect to the second subcell; and a distributed Bragg reflector adjacent the second or third subcell.

US 2011/011983 A1 describes a photovoltaic cell comprising a GaInP subcell comprising a disordered group-III sublattice, a Ga(In)As subcell disposed below the GaInP subcell, and a Ge substrate disposed below the Ga(In)As subcell comprising a surface misoriented from a plane by an angle from about 8 degrees to about 40 degrees toward a nearest plane.

R. R. KING ET AL: "Group-IV Subcells in Multijunction Concentrator Solar Cells", ECS TRANSACTIONS, vol. 50, no. 9, 15 March 2013, pages 287-295, describe multijunction solar cells having several types of Ge, Si, SiGe, and SiGeSn subcells. There is disclosed that cells incorporating both dilute nitride GaInNAs and active Ge substrate cells can reach over 46% production average efficiencies at 50.0 W/cm2 (500 suns), 25°C under the standard concentrated solar spectrum, with champion efficiencies over 48%.

Daniel J. Aiken: "InGaP/GaAs/Ge multi-junction solar cell efficiency improvements using epitaxial germanium", Proceedings of 28th IEEE, Photovoltaic Specialists Conference, 15-22.09.2000, pages 994-997, discloses two approaches for improving the efficiency of Ill-V multi-junctions beyond that of triple junction technology. Both of these approaches involve the use of thin epitaxial germanium and do not require the development of new 1 eV photovoltaic materials.

### SUMMARY OF THE DISCLOSURE

### Features of the Invention

The subject-matter of the present invention is defined in independent claim 1 (product) and in independent claim 11 (process). The present application is directed to solar cells with several substantially lattice matched subcells, but in some embodiments including at least one subcell which is lattice mismatched, and in a particular embodiment to a five junction (5J) solar cell using electrically coupled but spatially separated four junction (4J) semiconductor regions in a semiconductor body based on III-V semiconductor compounds.

All ranges of numerical parameters set forth in this disclosure are to be understood to encompass any and all subranges or "intermediate generalizations" subsumed herein. For example, a stated range of "1.0 to 2.0 eV" for a band gap value should be considered to include any and all subranges beginning with a minimum value of 1.0 eV or more and ending with a maximum value of 2.0 eV or less, e.g., 1.0 to 2.0, or 1.3 to 1.4, or 1.5 to 1.9 eV.

Briefly, and in general terms, the present disclosure describes solar cells that include a solar cell assembly of two or more solar cell subassemblies in a single monolithic semiconductor body composed of a tandem stack of solar subcells, where the subassemblies are interconnected electrically to one another.

As described in greater detail, the present application discloses that interconnecting two or more spatially split multijunction solar cell regions or subassemblies can be advantageous. The spatial split can be provided for multiple solar cell subassemblies monolithically formed on a single substrate and remaining as a monolithic semiconductor body with distinct characteristics. Alternatively, the solar cell subassemblies can be physically separated or fabricated individually as separate semiconductor chips that can be coupled together electrically. (Such alternative embodiments are covered in parallel applications, such as US 2017/0133542 A1 (U.S. Patent Application Serial No. 15/213,594).

One advantage of interconnecting two or more spatially split multijunction solar cell subassemblies or subregions is that such an arrangement can allow accumulation of the current from the upper subcells in the adjacent semiconductor regions into the bottom subcells which have higher current generation ability.

One advantage of interconnecting two or more spatially split multijunction solar cell subassemblies or subregions is that such an arrangement can allow the bottom subcells of different subassemblies or subregions to be connected in electrical series, this boosting the maximum operational voltage and open circuit voltage associated with the solar cell assembly, and thereby improving efficiency.

Further, selection of relatively high band gap semiconductor materials for the top subcells can provide for increased photoconversion efficiency in a multijunction solar cell for outer space or other applications over the operational life of the photovoltaic power system. For example, increased photoconversion efficiency at a predetermined time (measured in terms of five, ten, fifteen or more years) after initial deployment of the solar cell can be achieved.

Thus, in one aspect, a monolithic solar cell subassembly includes a semiconductor body including two regions each with an upper first solar subcell composed of (aluminum) indium gallium phosphide ((AI)InGaP); a second solar subcell disposed adjacent to and lattice matched to said upper first subcell, the second solar subcell composed of (aluminum) (indium) gallium arsenide ((Al)(In)GaAs) or indium gallium arsenide phosphide (InGaAsP); and a bottom subcell lattice matched to said second subcell and composed of (indium) gallium arsenide (In)GaAs.

The aluminum (or Al) constituent element, or indium (or In), shown in parenthesis in the preceding formula means that Al or In (as the case may be) is an optional constituent, and in the case of Al, in this instance may be used in an amount ranging from 0% to 40% by mole fraction. In some embodiments, the amount of aluminum may be between 20% and 30%. The subcells are configured so that the current density of the upper first subcell and the second subcell have a substantially equal predetermined first value, and the current density of the bottom subcell is at least twice that of the predetermined first value.

Briefly, and in general terms, the present disclosure provides a five junction solar cell comprising a semiconductor body including:
(a) a first semiconductor region including:
   an upper first solar subcell composed of a semiconductor material having a first band gap, and including a top contact on the top surface thereof;
   a second solar subcell adjacent to said first solar subcell and composed of a semiconductor material having a second band gap smaller than the first band gap and being lattice matched with the upper first solar subcell;
   a third solar subcell adjacent to said second solar subcell and composed of a semiconductor material having a third band gap smaller than the second band gap and being lattice matched with the second solar subcell;
   a fourth solar subcell adjacent to said third solar subcell and composed of a semiconductor material having a fourth band gap smaller than the third band gap and being lattice matched with the third solar subcell, and including a first contact on the top surface thereof, and a second contact on the bottom surface thereof;
(b) a second semiconductor region disposed adjacent and parallel to the first semiconductor region and including:
   an upper first solar subcell composed of a semiconductor material having a first band gap, and including a top contact on the top surface thereof;
   a second solar subcell adjacent to said first solar subcell and composed of a semiconductor material having a second band gap smaller than the first band gap and being lattice matched with the upper first solar subcell;
   a third solar subcell adjacent to said second solar subcell and composed of a semiconductor material having a third band gap smaller than the second band gap and being lattice matched with the second solar subcell and having a bottom contact;
   a fourth solar subcell adjacent to said third solar subcell and composed of a semiconductor material having a fourth band gap smaller than the third band gap and being lattice matched with the third solar subcell, and including a first contact on the top surface thereof, and a second contact on the bottom surface thereof connected to the terminal of a second polarity;
(c) wherein the top contact of the first semiconductor region is electrically coupled with the top contact of the second semiconductor region and to a terminal of first polarity;
   wherein the first contact on the top surface of the fourth solar subcell of the first semiconductor region is electrically coupled with the bottom contact of the third solar subcell of the second semiconductor region; and
   the second contact on the bottom surface of the fourth solar subcell of the first semiconductor region is electrically coupled with the first contact on the top surface of the fourth solar subcell of the second semiconductor region thereof so as to form a five junction solar cell.

In another aspect, the present disclosure provides a multijunction solar cell including a terminal of first polarity and a terminal of second polarity comprising first and second semiconductor regions in a single semiconductor body, each region including substantially identical tandem vertical stacks of at least an upper first and a second bottom solar subcell in which the second semiconductor region is disposed adjacent to and with respect to the incoming illumination, parallel to the first semiconductor region; a bottom contact on the bottom subcell of the second semiconductor region connected to the terminal of second polarity; a top electric contact on both the upper first subcells of the first and second semiconductor regions electrically connected to the top electrical contacts to the terminal of first polarity; and an electrical interconnect connecting the bottom second subcell of the first semiconductor region in a series electrical circuit with the bottom second subcell of the second semiconductor region so that at least a three junction solar cell is formed by the electrically interconnected semiconductor regions.

In another aspect, the present disclosure provides a method comprising:
(a) growing a sequence of semiconductor layers on a substrate forming a semiconductor body, the sequence of layers including an upper first solar subcell composed of a semiconductor material having a first band gap, and including a top contact region on the top surface thereof;
   a second solar subcell adjacent to said first solar subcell and composed of a semiconductor material having a second band gap smaller than the first band gap and being lattice matched with the upper first solar subcell;
   a third solar subcell adjacent to said second solar subcell and composed of a semiconductor material having a third band gap smaller than the second band gap and being lattice matched with the second solar subcell;
   a fourth solar subcell adjacent to said third solar subcell and composed of a semiconductor material having a fourth band gap smaller than the third band gap and being lattice matched with the third solar subcell, and including a first contact on the top surface thereof, and a second contact on the bottom surface thereof;
(b) etching the semiconductor body from the substrate or bottom side to form first and second adjacent but electrically isolated semiconductor regions, each region including:
   the upper first solar subcell;
   the second solar subcell;
   the third solar subcell; and
   in each region, a distinct and spatially separated fourth solar subcell.

In some embodiments, additional layer(s) may be added or deleted in the cell structure without departing from the scope of the claims.

Some implementations can include additional solar subcells in one or more of the semiconductor bodies.

Some implementations of the present disclosure may incorporate or implement fewer of the aspects and features noted in the foregoing summaries.

Additional aspects, advantages, and novel features of the present disclosure will become apparent to those skilled in the art from this disclosure, including the following detailed description as well as by practice of the disclosure. While the disclosure is described below with reference to preferred embodiments, it should be understood that the disclosure is not limited thereto. Those of ordinary skill in the art having access to the teachings herein will recognize additional applications, modifications and embodiments in other fields, without departing from the scope of the claims.

### BRIEF DESCRIPTION OF THE DRAWINGS

The invention will be better and more fully appreciated by reference to the following detailed description when considered in conjunction with the accompanying drawings, wherein:
FIG. 1 is a graph representing the BOL value of the parameter E_{g}/q - V_{oc} at 28° C plotted against the band gap of certain ternary and quaternary materials defined along the x-axis;
FIG. 2A is a cross-sectional view of a first embodiment of a semiconductor body including a four solar subcells after several stages of fabrication including the growth of certain semiconductor layers on the growth substrate up to the contact layer, according to the present disclosure;
FIG. 2B is a cross-sectional view of the embodiment of FIG. 2B following the steps of etching contact ledges on various semiconductor layers according to a first implementation in the present disclosure, and providing electrical connection of the first and second semiconductor regions by discrete electrical interconnects according to the present disclosure;
FIG. 3 is a bottom plan view of the solar cell of FIG. 2B depicting the electrical interconnects;
FIG. 4 is a graph of the doping profile in the base and emitter layers of a subcell in the solar cell according to the present disclosure; and
FIG. 5 is a schematic diagram of the five junction solar cell of FIG. 2B.

### DESCRIPTION OF THE PREFERRED EMBODIMENT

Details of the present invention will now be described including exemplary aspects and embodiments thereof. Referring to the drawings and the following description, like reference numbers are used to identify like or functionally similar elements, and are intended to illustrate major features of exemplary embodiments in a highly simplified diagrammatic manner. Moreover, the drawings are not intended to depict every feature of the actual embodiment nor the relative dimensions of the depicted elements, and are not drawn to scale.

A variety of different features of multijunction solar cells (as well as inverted metamorphic multijunction solar cells) are disclosed in the related applications noted above. Some, many or all of such features may be included in the structures and processes associated with the non-inverted or "upright" solar cells of the present disclosure. However, more particularly, the present disclosure is directed to the fabrication of a multijunction lattice matched solar cell grown on a single growth substrate which comprises two or more interconnected solar cell subregions or subassemblies. More specifically, however, in some embodiments, the present disclosure relates to a multijunction solar cell with direct band gaps in the range of 2.0 to 2.15 eV (or higher) for the top subcell, and (i) 1.65 to 1.8 eV, and (ii) 1.41 eV for the middle subcells, and 0.6 to 0.9 eV direct or indirect band gaps, for the bottom subcell(s), respectively, and the connection of two or more such subassemblies to form a solar cell assembly.

The present disclosure provides a solar cell subassembly with an unconventional four junction design (with three grown lattice matched subcells, which are lattice matched to the Ge substrate) that leads to significant performance improvement over that of traditional three junction solar cell on Ge despite the substantial current mismatch present between the top three junctions and the bottom Ge junction. This performance gain is especially realized at high temperature and after high exposure to space radiation by the proposal of incorporating high band gap semiconductors that are inherently more resistant to radiation and temperature.

As described in greater detail, the present application further notes that interconnecting two or more spatially split multijunction solar cell subregions or subassemblies (with each subassembly incorporating Applicant's unconventional design) can be even more advantageous. The spatial split can be provided for multiple solar cell subassemblies monolithically formed on the same substrate according to the present disclosure. Alternatively, the solar cell subassemblies can be fabricated as separate semiconductor chips that can be coupled together electrically, as described in related applications.

In general terms, a solar cell assembly in accordance with one aspect of the present disclosure, can include a terminal of first polarity and a terminal of second polarity. The solar cell assembly includes a first semiconductor subregion or subassembly including a tandem vertical stack of at least a first upper, a second, third and fourth bottom solar subcells, the first upper subcell having a top contact connected to the terminal of first polarity. A second semiconductor subregion or subassembly is disposed adjacent to the first semiconductor subregion or subassembly and includes a tandem vertical stack of at least a first upper, a second, third, and fourth bottom solar subcells, the fourth bottom subcell having a back side contact connected to the terminal of second polarity. The fourth subcell of the first semiconductor subregion is connected in a series electrical circuit with the third subcell of the second semiconductor subregion. Thus, a five-junction solar assembly is assembled from two four-junction solar cell subassemblies.

In some cases, the foregoing solar cell assembly can provide increased photoconversion efficiency in a multijunction solar cell for outer space or other applications over the operational life of the photovoltaic power system.

Another aspect of the present disclosure is that to provide a five junction solar cell assembly composed of an integral semiconductor body with two interconnected spatially separated four junction solar cell subassemblies or regions, the average band gap of all four subcells (i.e., the sum of the four band gaps of each subcell divided by 4) in each solar cell subassembly being greater than 1.44 eV.

Another descriptive aspect of the present disclosure is to characterize the fourth subcell as being composed of an indirect or direct band gap material such that the lowest direct band gap is greater than 0.75 eV, in some embodiments.

Another descriptive aspect of the present disclosure is to characterize the fourth subcell as being composed of a direct band gap material such that the lowest direct band gap is less than 0.90 eV, in some embodiments.

In some embodiments, the fourth subcell in each solar cell subassembly is germanium, while in embodiments not forming part of the invention the fourth subcell is InGaAs, GaAsSb, InAsP, InAlAs, or SiGeSn, InGaAsN, InGaAsNSb, InGaAsNBi, InGaAsNSbBi, InGaSbN, InGaBiN, InGaSbBiN or other III-V or II-VI compound semiconductor material.

The indirect band gap of germanium at room temperature is about 0.66 eV, while the direct band gap of germanium at room temperature is 0.8 eV. Those skilled in the art will normally refer to the "band gap" of germanium as 0.66 eV, since it is lower than the direct band gap value of 0.8 eV.

The recitation that "the fourth subcell has a direct band gap of greater than 0.75 eV" is therefore expressly meant to include germanium as a possible semiconductor for the fourth subcell. In embodiments not forming part of the invention, other semiconductor materials can be used as well.

More specifically, the present disclosure intends to provide a relatively simple and reproducible technique that does not employ inverted processing associated with inverted metamorphic multijunction solar cells, and is suitable for use in a high volume production environment in which various semiconductor layers are grown on a growth substrate in an MOCVD reactor, and subsequent processing steps are defined and selected to minimize any physical damage to the quality of the deposited layers, thereby ensuring a relatively high yield of operable solar cells meeting specifications at the conclusion of the fabrication processes.

The lattice constants and electrical properties of the layers in the semiconductor structure are preferably controlled by specification of appropriate reactor growth temperatures and times, and by use of appropriate chemical composition and dopants. The use of a deposition method, such as Molecular Beam Epitaxy (MBE), Organo Metallic Vapor Phase Epitaxy (OMVPE), Metal Organic Chemical Vapor Deposition (MOCVD), or other vapor deposition methods for the growth may enable the layers in the monolithic semiconductor structure forming the cell to be grown with the required thickness, elemental composition, dopant concentration and grading and conductivity type.

The present disclosure is directed to, in one embodiment, a growth process using a metal organic chemical vapor deposition (MOCVD) process in a standard, commercially available reactor suitable for high volume production. More particularly, the present disclosure is directed to the materials and fabrication steps that are particularly suitable for producing commercially viable multijunction solar cells using commercially available equipment and established high-volume fabrication processes, as contrasted with merely academic expositions of laboratory or experimental results.

Prior to discussing the specific embodiments of the present disclosure, a brief discussion of some of the issues associated with the design of multijunction solar cells, and in particular metamorphic solar cells, and the context of the composition or deposition of various specific layers in embodiments of the product as specified and defined by Applicant is in order.

There are a multitude of properties that should be considered in specifying and selecting the composition of, inter alia, a specific semiconductor layer, the back metal layer, the adhesive or bonding material, or the composition of the supporting material for mounting a solar cell thereon. For example, some of the properties that should be considered when selecting a particular layer or material are electrical properties (e.g. conductivity), optical properties (e.g., band gap, absorbance and reflectance), structural properties (e.g., thickness, strength, flexibility, Young's modulus, etc.), chemical properties (e.g., growth rates, the "sticking coefficient" or ability of one layer to adhere to another, stability of dopants and constituent materials with respect to adjacent layers and subsequent processes, etc.), thermal properties (e.g., thermal stability under temperature changes, coefficient of thermal expansion), and manufacturability (e.g., availability of materials, process complexity, process variability and tolerances, reproducibility of results over high volume, reliability and quality control issues).

In view of the trade-offs among these properties, it is not always evident that the selection of a material based on one of its characteristic properties is always or typically "the best" or "optimum" from a commercial standpoint or for Applicant's purposes. For example, theoretical studies may suggest the use of a quaternary material with a certain band gap for a particular subcell would be the optimum choice for that subcell layer based on fundamental semiconductor physics. As an example, the teachings of academic papers and related proposals for the design of very high efficiency (over 40%) solar cells may therefore suggest that a solar cell designer specify the use of a quaternary material (e.g., InGaAsP) for the active layer of a subcell. A few such devices may actually be fabricated by other researchers, efficiency measurements made, and the results published as an example of the ability of such researchers to advance the progress of science by increasing the demonstrated efficiency of a compound semiconductor multijunction solar cell. Although such experiments and publications are of "academic" interest, from the practical perspective of the Applicants in designing a compound semiconductor multijunction solar cell to be produced in high volume at reasonable cost and subject to manufacturing tolerances and variability inherent in the production processes and suited for specific applications such as the space environment where the efficiency over the entire operational life is an important goal, such an "optimum" design from an academic perspective is not necessarily the most desirable design in practice, and the teachings of such studies more likely than not point in the wrong direction and lead away from the proper design direction. Stated another way, such references may actually "teach away" from Applicant's research efforts and the ultimate solar cell design proposed by the Applicants.

In view of the foregoing, it is further evident that the identification or proportion of one particular constituent element (e.g., indium, or aluminum) in a particular subcell, or the thickness, band gap, doping, or other characteristic of the incorporation of that material in a particular subcell, in not a single, independent "result effective variable" that one skilled in the art can simply specify and incrementally adjust to a particular level and thereby increase the efficiency of a solar cell and its power output. The efficiency of a solar cell is not a simple linear algebraic equation as a function of the amount of gallium or aluminum or other element or material variable in a particular layer. The electrical characteristics of a semiconductor layer, such as the short circuit current (J_{sc}), the open circuit voltage (V_{oc}), and the fill factor (FF), are affected by several factors such as the number of subcells, the thickness of each subcell, the composition and doping of each active layer in a subcell. The consequential band structure, electron energy levels, conduction, and absorption of photons of different wavelengths and diffusion lengths in each subcell are not easily mathematically computable as a function of any one, two or small number of distinct single material variables. As an example, the power output may be stipulated to be a product of voltage and current in a subcell, but a simpleminded "result effective variable" approach to change a material variable (such as the amount of an element or doping in the layer), to thereby increase the voltage in a subcell in anticipation that it may result in greater power output, may in fact lead to a decrease in current, or a current mismatch between adjacent subcells in a tandem solar cell, or other interdependent effects (e.g., increased dopants diffusing into other layers and thereby adversely affecting them), with the overall effect of decreasing the power output of the solar cell.

The growth of each of the epitaxial layers of a solar cell in an MOCVD reactor is a nonequilibrium thermodynamic process with dynamically changing spatial and temporal boundary conditions that is not readily or predictably modeled. The formulation and solution of the relevant simultaneous partial differential equations covering such processes are not within the ambit of those of ordinary skill in the art in the field of solar cell design.

Another aspect of the disclosure is to match the larger short circuit current of the bottom subcell of the solar cell assembly with two or three parallel stacks of solar subcells, i.e. a configuration in which the value of the short circuit current of the bottom subcell is at least twice, or at least three times, that of the solar subcells in each parallel stack which are connected in series with the bottom subcell. Stated another way, given the choice of the composition of the bottom subcell, and thereby the short circuit current of the bottom subcell, the upper subcell stack is specified and designated to have a short circuit current which is one - third or less or is one - half or less than that of the bottom subcell.

Even when it is known that particular variables have an impact on electrical, optical, chemical, thermal or other characteristics, the nature of the impact often cannot be predicted with much accuracy, particularly when the variables interact in complex ways, leading to unexpected results and unintended consequences. Thus, significant trial and error, which may include the fabrication and evaluative testing of many prototype devices, often over a period of time of months if not years, is required to determine whether a proposed structure with layers of particular compositions, actually will operate as intended, in a given environment over the operational life, let alone whether it can be fabricated in a reproducible high volume manner within the manufacturing tolerances and variability inherent in the production process, and necessary for the design of a commercially viable device.

Furthermore, as in the case here, where multiple variables interact in unpredictable ways, the proper choice of the combination of variables can produce new and "unexpected results", and constitute an "inventive step" in designing and specifying a solar cell to operate in a predetermined environment (such as space), not only at the beginning of life, but over the entire defined operational lifetime.

Reference throughout this specification to "one embodiment" or "an embodiment" means that a particular feature, structure, or characteristic described in connection with the embodiment is included in at least one embodiment of the present invention. Thus, the appearances of the phrases "in one embodiment" or "in an embodiment" in various places throughout this specification are not necessarily all referring to the same embodiment. Furthermore, the particular features, structures, or characteristics may be combined in any suitable manner in one or more embodiments.

One aspect of the present disclosure relates to the use and amount of aluminum in the active layers of the upper subcells in a multijunction solar cell (i.e. the subcells that are closest to the primary light source). The effects of increasing amounts of aluminum as a constituent element in an active layer of a subcell affects the photovoltaic device performance. One measure of the "quality" or "goodness" of a solar cell subcell or junction is the difference between the band gap of the semiconductor material in that subcell or junction and the V_{oc}, or open circuit voltage, of that same junction. The smaller the difference, the higher the V_{oc} of the solar cell junction relative to the band gap, and the better the performance of the device. V_{oc} is very sensitive to semiconductor material quality, so the smaller the E_{g}/q - V_{oc} of a device, the higher the quality of the material in that device. There is a theoretical limit to this difference, known as the Shockley-Queisser limit. That is the best voltage that a solar cell junction can produce under a given concentration of light at a given temperature.

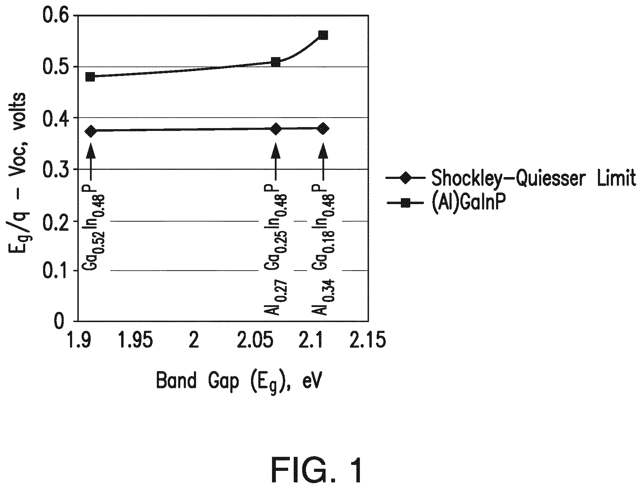

The experimental data obtained for single junction (AI)GaInP solar cells indicates that increasing the Al content of the junction leads to a larger E_{g}/q - V_{oc} difference, indicating that the material quality of the junction decreases with increasing Al content. Figure 1 shows this effect. The three compositions cited in the Figure are all lattice matched to GaAs, but have differing Al composition. As seen by the different compositions represented, with increasing amount of aluminum represented by the x-axis, adding more Al to the semiconductor composition increases the band gap of the junction, but in so doing also increases E_{g}/q - V_{oc}. Hence, we draw the conclusion that adding Al to a semiconductor material degrades that material such that a solar cell device made out of that material does not perform relatively as well as a junction with less Al.

Thus, contrary to the conventional wisdom as indicated above, the present application utilizes a substantial amount of aluminum, i.e., over 20% aluminum by mole fraction in at least the top subcell, and in some embodiments in one or more of the middle subcells.

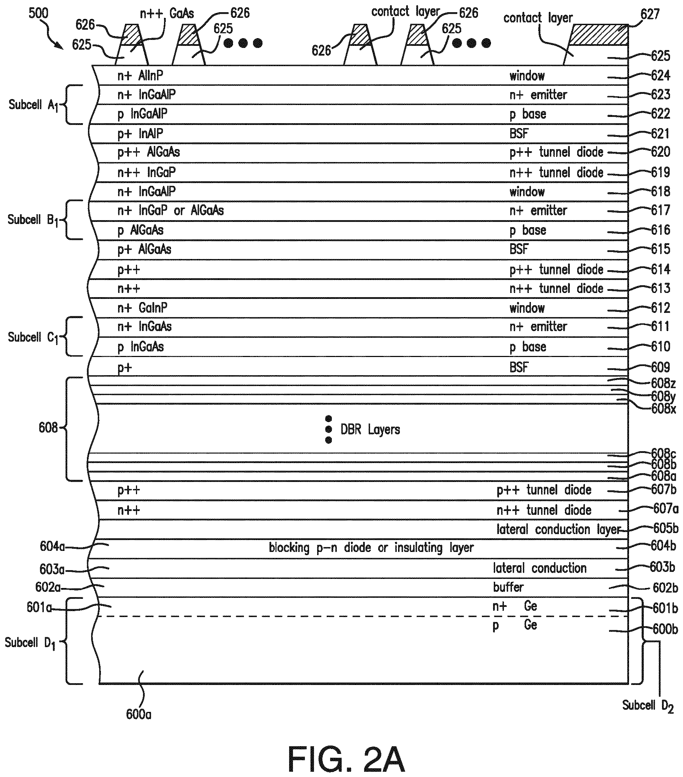

Turning to the fabrication of the multijunction solar cell assembly of the present disclosure, and in particular a five-junction solar cell assembly, FIG. 2A is a cross-sectional view of a first embodiment of a semiconductor body 500 after several stages of fabrication including the growth of certain semiconductor layers on the growth substrate, and formation of grids and contacts on the contact layer of the top side (i.e., the light-facing side) of the semiconductor body.

As shown in the illustrated example of FIG. 2A, the bottom subcell (which we refer to initially as subcell D) includes a substrate 600 formed of p-type germanium ("Ge") in some embodiments, which also serves as a base layer of the subcell (i.e., the p-polarity layer of a "base-emitter" photovoltaic junction formed by adjacent layers of opposite conductivity type).

In some embodiments, the bottom subcell D is germanium, while in other embodiments not forming part of the invention the fourth subcell is InGaAs, GaAsSb, InAsP, InAlAs, or SiGeSn, InGaAsN, InGaAsNSb, InGaAsNBi, InGaAsNSbBi, InGaSbN, InGaBiN, InGaSbBiN or other III-V or II-VI compound semiconductor material.

The bottom subcell D, further includes, for example, a highly doped n-type Ge emitter layer 601, and an n-type indium gallium arsenide ("InGaAs") nucleation layer 602. The nucleation layer or buffer 602 is deposited over the base layer, and the emitter layer 601 is formed in the substrate by diffusion of atoms from the nucleation layer 602 into the Ge substrate, thereby forming the n-type Ge layer 601b.

A highly doped first lateral conduction layer 603 is deposited over layer 602, and a blocking p-n diode or insulating layer 604 is deposited over the layer 603. A second highly doped lateral conduction layer 605 is then deposited over layer 604.

Heavily doped p-type aluminum gallium arsenide ("AlGaAs") and heavily doped n-type indium gallium arsenide ("(In)GaAs") tunneling junction layers 606, 607 may be deposited over the second lateral conduction layer 605 to provide a low resistance pathway between the bottom D and the middle subcell C.

In some embodiments, distributed Bragg reflector (DBR) layers 608 are then grown adjacent to and between the tunnel junction 606/607 and the third solar subcell C₁. The DBR layers 608 are arranged so that light can enter and pass through the third solar subcell C₁ and at least a portion of which can be reflected back into the third solar subcell C₁ by the DBR layers 608. In the embodiment depicted in FIG. 2A, the distributed Bragg reflector (DBR) layers 608 are specifically located between the third solar subcell C and tunnel junction layers 607; in other embodiments, the distributed Bragg reflector tunnel diode layers 606/607 may be located between DBR layer 608 and the third subcell C₁.

For some embodiments, distributed Bragg reflector (DBR) layers 608 can be composed of a plurality of alternating layers 608a through 608z of lattice matched materials with discontinuities in their respective indices of refraction. For certain embodiments, the difference in refractive indices between alternating layers is maximized in order to minimize the number of periods required to achieve a given reflectivity, and the thickness and refractive index of each period determines the stop band and its limiting wavelength.

For some embodiments, distributed Bragg reflector (DBR) layers 608a through 608z includes a first DBR layer composed of a plurality of p type Alₓ(In)Ga₁₋ₓAs layers, and a second DBR layer disposed over the first DBR layer and composed of a plurality of p type Al_{y}(In)Ga_{1-y}As layers, where y is greater than x, with 0 < x < 1, 0 < y < 1.

On top of the DBR layers 608 the subcell C₁ is grown.

In the illustrated example of FIG. 2A, the subcell C₁ includes a highly doped p-type aluminum gallium arsenide ("Al(In)GaAs") back surface field ("BSF") layer 609, a p-type InGaAs base layer 610, a highly doped n-type indium gallium phosphide ("InGaP2") emitter layer 611 and a highly doped n-type indium aluminum phosphide ("AlInP2") window layer 612. The InGaAs base layer 610 of the subcell C₁ can include, for example, approximately 1.5% In. Other compositions may be used as well. The base layer 610 is formed over the BSF layer 609 after the BSF layer is deposited over the DBR layers 608a through 608z.

The window layer 612 is deposited on the emitter layer 611 of the subcell C₁. The window layer 612 in the subcell C₁ also helps reduce the recombination loss and improves passivation of the cell surface of the underlying junctions. Before depositing the layers of the subcell B, heavily doped n-type InGaP and p-type AI(In)GaAs (or other suitable compositions) tunneling junction layers 613, 614 may be deposited over the subcell C₁.

The middle subcell B₁ includes a highly doped p-type aluminum (indium) gallium arsenide ("Al(In)GaAs") back surface field ("BSF") layer 615, a p-type Al(In)GaAs base layer 616, a highly doped n-type indium gallium phosphide ("InGaP2") or Al(In)GaAs layer 617 and a highly doped n-type indium gallium aluminum phosphide ("AlGaAIP") window layer 618. The InGaP emitter layer 617 of the subcell B₁ can include, for example, approximately 50% In. Other compositions may be used as well.

Before depositing the layers of the top cell A₁, heavily doped n-type InGaP and p-type AI(In)GaAs tunneling junction layers 619, 620 may be deposited over the subcell B.

In the illustrated example, the top subcell A₁ includes a highly doped p-type indium aluminum phosphide ("InAlP") BSF layer 621, a p-type InGaAlP base layer 622, a highly doped n-type InGaAlP emitter layer 623 and a highly doped n-type InAlP2 window layer 624. The base layer 623 of the top subcell A₁ is deposited over the BSF layer 621 after the BSF layer 621 is formed over the tunneling junction layers 619, 620 of the subcell B₁. The window layer 624 is deposited over the emitter layer 623 of the top subcell A₁ after the emitter layer 623 is formed over the base layer 622.

In some embodiments, the amount of aluminum in the top subcell A, is 20% or more by mole fraction.

A cap or contact layer 625 may be deposited and patterned into separate contact regions over the window layer 624 of the top subcell A₁. After further processing, the solar cell assembly 500 can be provided with grid lines 626, interconnecting bus lines, and contact pads 627 on the top surface. The geometry and number of the grid lines, bus lines and/or contacts may vary in different implementations.

The cap or contact layer 625 serves as an electrical contact from the top subcell A₁ to metal grid 626. The doped cap or contact layer 625 can be a semiconductor layer such as, for example, a GaAs or InGaAs layer.

After the cap or contact layer 625 is deposited, the grid lines 626 are formed via evaporation and lithographically patterned and deposited over the cap or contact layer 625.

A contact pad 627 connected to the grid 626 is formed on one edge of the subassembly 500 to allow an electrical interconnection to be made, inter alia, to an adjacent subassembly.

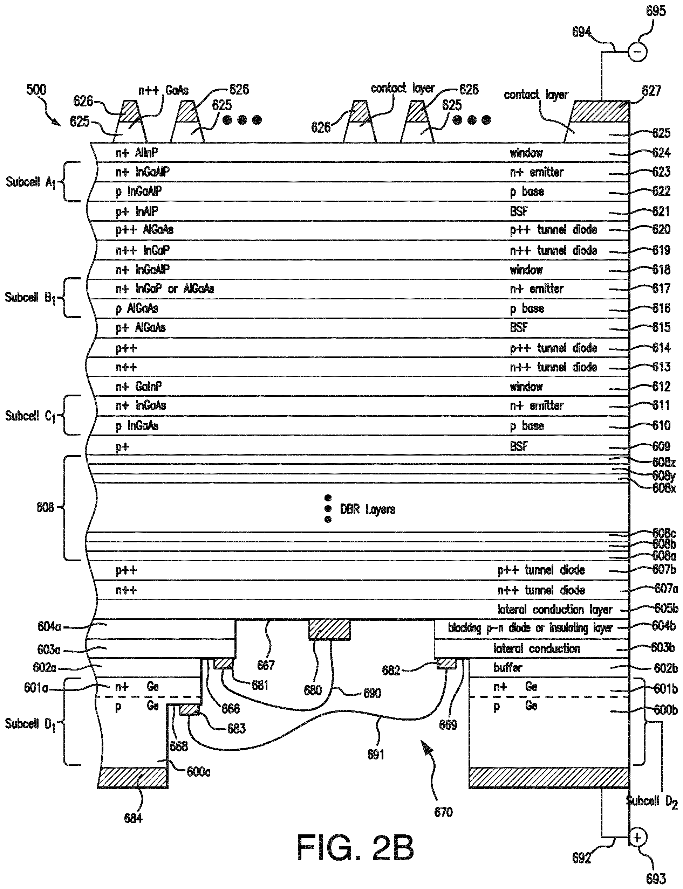

Turning to FIG. 2B, following the deposition of the semiconductor layers 602 through 625, the semiconductor body 500 is partially etched from the backside (i.e., through the substrate 600) to form a channel 670 that bisects the wafer or the fourth solar subcell of the semiconductor body, and several ledges or platforms are formed on intermediate layers so that electrical contacts are made thereto, in particular, in one embodiment depicted in this Figure, ledges 666, 667, and 668.

The third ledge 668 in the substrate 600 is etched to allow electrical contact to be made to the p terminal of subcell D₁.

To this end, the solar cell assembly can include a plurality of openings in the semiconductor body, each of the openings extending from a bottom surface of the semiconductor body to a different respective layer in the semiconductor body. Such "openings" may include recesses, cavities, holes, gaps, cut-outs, or similar structures, but for simplicity we will subsequently just use the term "opening" throughout this disclosure. In other implementations, we can etch through the top or the side of the substrate and have some or all the openings come from one or more sides. This approach may be more efficient than etching from the top side as it does not shadow the top two or top three solar subcells, and results in a solar epitaxial structure of only a few tens of microns in thickness.

As a result of the etching process depicted in FIG. 2B, the semiconductor body 500 is divided into two semiconductor regions, with one 698 depicted on the left hand side of the Figure and one 699 on the right hand side. The bottom surface of a portion of the highly doped second lateral conduction layer 605 is exposed by the etching process and forms a ledge 667. The blocking p-n diode or insulating layer 604 is divided into two portions, with one in each of the respective semiconductor region, one portion 604a being on the left 698 and one portion 604b being on the right 699 of the Figure. Similarly, the first highly doped lateral conduction layer 603 is divided into two parts, with one in each respective semiconductor region, one portion 603a on the left 698 and one portion 603b on the right 699 of the Figure. A ledge 666 is formed on the left portion 603a of the first highly doped lateral conduction layer 603, and a ledge 669 is formed on the right portion 603b of the first highly doped lateral conduction layer 603.

The buffer layer 602 and the subcell D 600/601 is divided into two semiconductor regions. One portion 602a of the buffer layer on the left hand side 698 of the Figure and one portion 602b of the buffer layer on the right hand side 699. One portion 600a/601a of the solar subcell D (which we now designate as solar subcell D₁) on the left hand side 698 of the Figure and one portion 600a/601a of the solar cell D (which we now designate as solar subcell D₂) the right hand side 699. A ledge 668 is formed on the left portion 600a of the subcell D₁.

The subcells A₁, B₁, C₁ of the left portion 698 of the solar cell 500 can be configured so that the short circuit current densities of the three subcells A₁, B₁, C₁ have a substantially equal predetermined first value (i.e., J1 = J2 = J3), and the short circuit current density (J4) of the bottom subcell D, is at least twice that of the predetermined first value.

As with the left portion 698 of solar cell 500, the subcells A₂, B₂, C₂ of the right hand solar cell 699 can be configured so that the short circuit current densities of the three subcells A₂, B₂, C₂ have a substantially equal predetermined first value (J1 = J2 = J3), and the short circuit current density (J4) of the bottom subcell D₂ is at least twice that of the predetermined first value.

FIG. 2B also depicts the additional stages of fabrication including the deposition of metal contact pads on the ledges depicted in FIG. 2B.

A metal contact pad 680 is deposited on the surface of the ledge of 667 which exposes a portion of the bottom surface of the lateral conduction layer 605b. This pad 680 allows electrical contact to be made to the bottom of the stack of subcells A₁ through C₁.

A metal contact pad 681is deposited on the surface of the ledge of 666 which exposes a portion of the bottom surface of the lateral conduction layer 603a. This pad 681 allows electrical contact to be made to the n-polarity terminal of subcell D₁.

A metal contact pad 682 is deposited on the surface of the ledge of 669 which exposes a portion of the bottom surface of the lateral conduction layer 603b. This pad 682 allows electrical contact to be made to the n-polarity terminal of subcell D₂.

A metal contact pad 683 is deposited on the surface of the ledge of 668 which exposes a portion of the surface of the p-polarity region of subcell D₁. Alternatively, contact may be made to a part of the back metal layer 684, which allows electrical contact to be made to the p-terminal of subcell D₁.

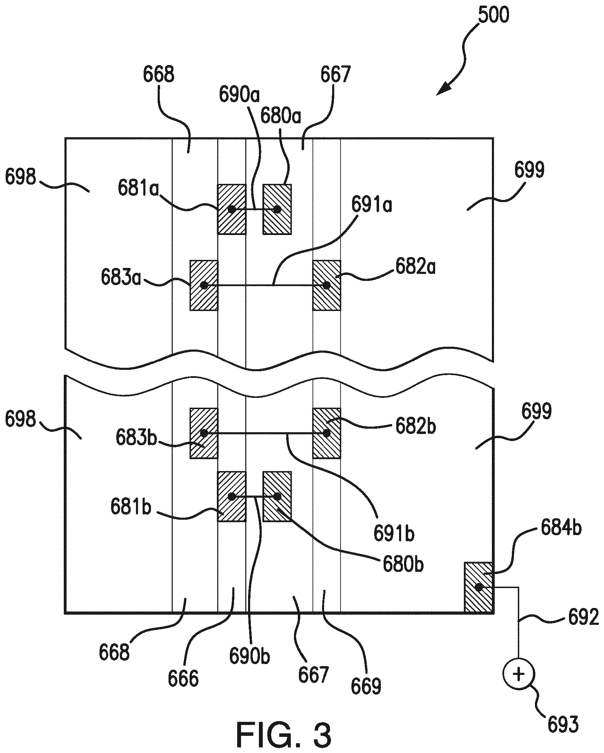

For example, as shown in the bottom plan view of the solar cell 500 depicted in FIG. 3, conductive (e.g., metal) interconnections 690 (i.e., 690a and 690b), and 691 (i.e., 691a and 691b) can be made between different layers of the solar cell subregions 698 and 699. Similarly, the interconnection 691 connects together a contact 683 on the p-region 600a of the solar subcell D, to a contact 682 on the lateral conduction layer 603b associated with the solar subcell D₂. Likewise, the interconnection 690 connects together a contact 681 on the lateral conduction layer 603a associated with the solar subcell D, to a contact 680 on the lateral conduction layer 605a and 605b.

As noted above, the solar cell assembly includes a first electrical contact of a first polarity and a second electrical contact of a second polarity. In some embodiments, the first electrical contact 695 is connected to the metal contact 627 on the solar cell subassembly 500 by an interconnection 694, and the second electrical contact 693 is connected to the back metal contact 684b of the solar subcell D₂ by interconnection 692, shown in FIG. 3.

As illustrated in FIG. 3, two or more solar cell subregions 698 and 699 can be connected electrically as described above to obtain a multijunction (e.g. a four-, five- or sixjunction) solar cell assembly.

Some implementations provide that at least the base of at least one of the first, second or third solar subcells has a graded doping, i.e., the level of doping varies from one surface to the other throughout the thickness of the base layer. In some embodiments, the gradation in doping is exponential. In some embodiments, the gradation in doping is incremental and monotonic.

In some embodiments, the emitter of at least one of the first, second or third solar subcells also has a graded doping, i.e., the level of doping varies from one surface to the other throughout the thickness of the emitter layer. In some embodiments, the gradation in doping is linear or monotonically decreasing.

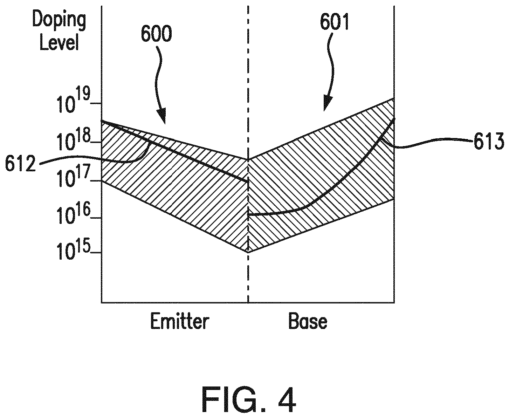

As a specific example, the doping profile of the emitter and base layers may be illustrated in Figure 4, which depicts the amount of doping in the emitter region and the base region of a subcell. N-type dopants include silicon, selenium, sulfur, germanium or tin. P-type dopants include silicon, zinc, chromium, or germanium.

In the example of Figure 4, in some embodiments, one or more of the subcells have a base region having a gradation in doping that increases from a value in the range of 1 × 10¹⁵ to 1 × 10¹⁸ free carriers per cubic centimeter adjacent the p-n junction to a value in the range of 1 × 10¹⁶ to 4 × 10¹⁸ free carriers per cubic centimeter adjacent to the adjoining layer at the rear of the base, and an emitter region having a gradation in doping that decreases from a value in the range of approximately 5 × 10¹⁸ to 1 × 10¹⁷ free carriers per cubic centimeter in the region immediately adjacent the adjoining layer to a value in the range of 5 × 10<15>to 1 × 10<18>free carriers per cubic centimeter in the region adjacent to the p-n junction.

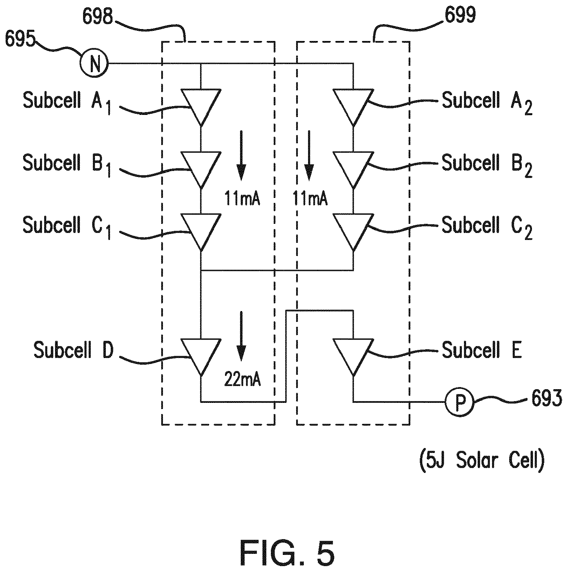

FIG. 5 is a schematic diagram of the five junction solar cell assembly of FIG. 2B that includes two solar cell semiconductor regions, each of which includes four subcells. The bottom (i.e., fourth) subcell D1of the left region 698 is connected in a series electrical circuit with the bottom (i.e., fourth) subcell D2of the right region 699. On the other hand, the upper and middle subcells are connected in parallel with one another (i.e., subcells A1, B1, C1are connected in parallel with subcells A2, B2, C2).

In some implementations of a five-junction solar cell assembly, such as in the example of FIG. 5 , the short circuit density (Jsc) of the upper first subcells (A1and A2) and the middle subcells (B1, B2, C1, C2) is about 11 mA/cm<2>, and the short circuit current density (Jsc) of the bottom subcells (D1and D2) is about 22 mA/cm<2>or greater. Other implementations may have different values.

The present disclosure like that of the parallel applications, US 2017/054048 A1 and US 2017/133542 A1 (U.S. Patent Applications Serial Nos. 14/828,206 and 15/213,594), provides a multijunction solar cell that follows a design rule that one should incorporate as many high band gap subcells as possible to achieve the goal to increase the efficiency at high temperature EOL. For example, high band gap subcells may retain a greater percentage of cell voltage as temperature increases, thereby offering lower power loss as temperature increases. As a result, both high temperature beginning-of-life (HT-BOL) and HT-EOL performance of the exemplary multijunction solar cell, according to the present disclosure, may be expected to be greater than traditional cells.

The open circuit voltage (Voc) of a compound semiconductor subcell loses approximately 2 mV per degree C as the temperature rises, so the design rule taught by the present disclosure takes advantage of the fact that a higher band gap (and therefore higher voltage) subcell loses a lower percentage of its Vocwith temperature. For example, a subcell that produces a 1.50 volts at 28° C produces 1.50 - 42*(0.0023) = 1.403 volts at 70° C which is a 6.4% voltage loss, A cell that produces 0.25 volts at 28° C produces 0.25 - 42*(0.0018) = 0.174 volts at 70° which is a 30.2% voltage loss.

In view of different satellite and space vehicle requirements in terms of temperature, radiation exposure, and operation life, a range of subcell designs using the design principles of the present disclosure may be provided satisfying typical customer and mission requirements, and several embodiments are set forth hereunder, along with the computation of their efficiency at the end-of-life. The radiation exposure is experimentally measured using 1 MeV electron fluence per square centimeter (abbreviated in the text that follows as e/cm<2>), so that a comparison can be made between the current commercial devices and embodiments of solar cells discussed in the present disclosure.

As an example, a low earth orbit (LEO) satellite will typically experience radiation equivalent to 5 x 10<14>e/cm<2>over a five year lifetime. A geosynchronous earth orbit (GEO) satellite will typically experience radiation in the range of 5 × 10¹⁴ e/cm² to 1 × 10 e/cm² over a fifteen year lifetime.

For example, the cell efficiency (%) measured at room temperature (RT) 28° C and high temperature (HT) 70° C, at beginning of life (BOL) and end of life (EOL), for a standard three junction commercial solar cell (e.g. a SolAero Technologies Corp. Model ZTJ), such as depicted in FIG. 2 of U.S. Patent Application Serial No. 14/828,206, is as follows:

| Condition | Efficiency | |
|---|---|---|
| BOL 28° C | 29.1% | |
| BOL 70° C | 26.4% | |
| EOL 70° C | 23.4% | After 5E14 e/cm² radiation |
| EOL 70°C | 22.0% | After 1E15 e/cm² radiation |

For the 5J solar cell assembly (comprising two interconnected four-junction subassemblies) described in the present disclosure, the corresponding data is as follows:

| Condition | Efficiency | |
|---|---|---|
| BOL 28° C | 30.6% | |
| BOL 70° C | 27.8% | |
| EOL 70° C | 26.6 % | After 5E14 e/cm² radiation |
| EOL 70° C | 26.1% | After 1E15 e/cm² radiation |

The new solar cell of the present disclosure has a slightly higher cell efficiency than the standard commercial solar cell (ZTJ) at BOL at 70° C. However, more importantly, the solar cell described in the present disclosure exhibits substantially improved cell efficiency (%) over the standard commercial solar cell (ZTJ) at 1 MeV electron equivalent fluence of 5 × 10¹⁴ e/cm², and dramatically improved cell efficiency (%) over the standard commercial solar cell (ZTJ) at 1 MeV electron equivalent fluence of 1 × 10¹⁵ e/cm².

The selected radiation exposure levels noted above are meant to simulate the environmental conditions of typical satellites in earth orbit as noted above.

The exemplary solar cell described herein may require the use of aluminum in the semiconductor composition of each of the top two subcells. Aluminum incorporation is widely known in the III-V compound semiconductor industry to degrade BOL subcell performance due to deep level donor defects, higher doping compensation, shorter minority carrier lifetimes, and lower cell voltage and an increased BOL E_{g}/q - V_{oc} metric. However, consideration of the EOL E_{g}/q - V_{oc} metric, or more generally, total power output over a defined predetermined operational life, in the present disclosure presents a different approach. In short, increased BOL E_{g}/q - V_{oc} may be the most problematic shortcoming of aluminum containing subcells; the other limitations can be mitigated by modifying the doping schedule or thinning base thicknesses.

It will be understood that each of the elements described above, or two or more together, also may find a useful application in other types of structures or constructions differing from the types of structures or constructions described above.

## Claims

1. A multijunction solar cell having a terminal of a first polarity (695) and a terminal of a second polarity (693) comprising a semiconductor body (500)
including:
(a) a first semiconductor region (698) including:
an upper first solar subcell (A1) composed of a semiconductor material having a first band gap, and including a top contact on the top surface thereof;
a second solar subcell (B1) adjacent to said first solar subcell (A1) and composed of a semiconductor material having a second band gap smaller than the first band gap and being lattice matched with the upper first solar subcell (A1);
a third solar subcell (C1) adjacent to said second solar subcell (B1) and composed of a semiconductor material having a third band gap smaller than the second band gap and being lattice matched with the second solar subcell (B1);
a fourth solar subcell (D1, D) adjacent to said third solar subcell (C1) and composed of a semiconductor material having a fourth band gap smaller than the third band gap and being lattice matched with the third solar subcell (C1), and including a first contact on the top surface thereof, and a second contact on the bottom surface thereof;
(b) a second semiconductor region (699) disposed adjacent and parallel to the first semiconductor region (698) and including:
an upper first solar subcell (A2) composed of a semiconductor material having a first band gap, and including a top contact on the top surface thereof;
a second solar subcell (B2) adjacent to said first solar subcell (A2) and composed of a semiconductor material having a second band gap smaller than the first band gap and being lattice matched with the upper first solar subcell (A2);
a third solar subcell (C2) adjacent to said second solar subcell (B2) and composed of a semiconductor material having a third band gap smaller than the second band gap and being lattice matched with the second solar subcell (B2) and having a bottom contact;
a fourth solar subcell (D2, E) fEr adjacent to said third solar subcell (C2) and
composed of a semiconductor material having a fourth band gap smaller than the third band gap and being lattice matched with the third solar subcell (C2), and including a first contact on the top surface thereof, and a second contact on the bottom surface thereof connected to the terminal of a second polarity;
(c) wherein the top contact of the first semiconductor region (698) is electrically coupled with the top contact of the second semiconductor region (699) and to a terminal of first polarity (695);
wherein the first contact on the top surface of the fourth solar subcell (D1, D) of the first semiconductor region (698) is electrically coupled with the bottom contact of the third solar subcell (C2) of the second semiconductor region (699);
the second contact on the bottom surface of the fourth solar subcell (D1, D) of the first semiconductor region (698) is electrically coupled with the first contact on the top surface of the fourth solar subcell (D2, E) of the second semiconductor region (699) thereof so as to form a five junction solar cell;
the semiconductor body further comprises a first highly doped lateral conduction layer (603a, 603b) disposed adjacent to and above the fourth solar subcell (D1, D2, D, E) and
a blocking p-n diode or insulating layer (604a, 604b) disposed adjacent to and above the first highly doped lateral conduction layer, and the first and second semiconductor regions (698, 699) further comprise a second highly doped lateral conduction layer (605b) disposed adjacent to and above the blocking p-n diode or insulating layer (604a, 604b);
the value of the short circuit current of the fourth subcell (D1, D2, D, E) is at least twice that of the solar subcells (A1, B1, C1, A2, B2, C2) in each parallel stack which are connected in series with the fourth subcell (D1, D2, D, E); and
the semiconductor body is partially etched from the backside to form a channel (670) that bisects the fourth solar subcell of the semiconductor body (500), and several ledges or platforms are formed on intermediate layers so that electrical contacts can be made thereto.

2. A multijunction solar cell as defined in claim 1, wherein the fourth subcell has a band gap of approximately 0.67 eV, the third subcell has a band gap in the range of approximately 1.41 eV to
1.31 eV, the second subcell has a band gap in the range of approximately 1.65 to 1.8 eV and the upper first subcell has a band gap in the range of 2.0 to 2.20 eV.

3. A multijunction solar cell as defined in claim 2, the third subcell has a band gap of approximately 1.37 eV, the second subcell has a band gap of approximately 1.73 eV and the upper first subcell has a band gap of approximately 2.10 eV.

4. A multijunction solar cell as defined in claim 1, wherein:
the upper first subcell is composed of indium gallium aluminum phosphide;
the second solar subcell includes an emitter layer composed of indium gallium phosphide or aluminum gallium arsenide, and a base layer composed of aluminum gallium arsenide or indium gallium arsenide phosphide;
the third solar subcell is composed of indium gallium arsenide; and
the fourth subcell is composed of germanium.

5. A multijunction solar cell as defined in claim 1, further comprising:
a distributed Bragg reflector (DBR) layer adjacent to and between the third and the fourth solar subcells and arranged so that light can enter and pass through the third solar subcell and at least a portion of which can be reflected back into the third solar subcell by the DBR layer, and the distributed Bragg reflector layer is composed of a plurality of alternating layers of lattice matched materials with discontinuities in their respective indices of refraction and the difference in refractive indices between alternating layers is maximized in order to minimize the number of periods required to achieve a given reflectivity, and the thickness and refractive index of each period determines the stop band and its limiting wavelength, and wherein the DBR layer includes a first DBR layer composed of a plurality of p type AlₓGa₁₋ₓ(In)As layers, and a second DBR layer disposed over the first DBR layer and composed of a plurality of n type or p type Al_{y}Ga_{1-y}(In)As layers, where 0 < x < 1, 0 < y < 1, and y is greater than x, and (In) designates that indium is an optional constituent.

6. A multijunction solar cell as defined in claim 1, wherein the amount of aluminum in the upper first subcell is at least 10% by mole fraction.

7. A multijunction solar cell as defined in claim 4, wherein the short circuit current density (J_{sc}) of the first, second and third middle subcells are approximately 11 mA/cm², and the short circuit current density (J_{sc}) of the bottom subcell is approximately 22 mA/cm².

8. A multijunction solar cell as defined in claim 1, wherein the short circuit density (J_{sc}) of the bottom subcell is at least three times that of the first, second and third subcells, with the base region of such subcell having a gradation in doping that increases from the base - emitter junction to the bottom of the base region in the range of 1 × 10¹⁵ to 5 × 10¹⁸ per cubic centimeter.

9. A multijunction solar cell as defined in claim 1 comprising:
a first opening in the first semiconductor region (698) extending from a bottom surface of the semiconductor body (500) to the first lateral conduction layer (604a);
a second opening in the first semiconductor region (698) extending from the bottom surface of the semiconductor body (500) to the second lateral conduction layer(603a); and
a third opening in the first semiconductor region (698) extending from the bottom surface of the first semiconductor body (500) to the p-type semiconductor material (600a) of the bottom subcell (D1).

10. A multijunction solar cell as defined in claim 9, further comprising:
a first metallic contact pad (680) disposed on the first lateral conduction layer (605b) of each of the first and second semiconductor regions; and
a second metallic contact pad (681) disposed on the second lateral conduction layer (603a) of the first semiconductor region;
an electrical interconnect (690) connecting the first and second contact pads (680, 681), a third metallic contact pad (682) disposed on the second lateral conduction layer (603b) of the second semiconductor region;
a fourth metallic contact pad (683) disposed on the p-type semiconductor material (600a) of the bottom subcell (D1) of the first semiconductor region; and
an electrical interconnect (691) connecting the third and fourth contact pads (682, 683).

11. A method of fabricating a multijunction solar cell comprising:
(a) growing a sequence of semiconductor layers on a substrate forming a semiconductor body (500) with a first semiconductor region (698) and a second semiconductor region (699), the sequence of layers including:
an upper first solar subcell (A1, A2) composed of a semiconductor material having a first band gap, and including a top contact region on the top surface thereof;
a second solar subcell (B1, B2) adjacent to said first solar subcell (A1, A2) and composed of a semiconductor material having a second band gap smaller than the first band gap and being lattice matched with the upper first solar subcell (A1, A2);
a third solar subcell (C1, C2) adjacent to said second solar subcell (B1, B2) and composed of a semiconductor material having a third band gap smaller than the second band gap and being lattice matched with the second solar subcell (B1, B2); and
a fourth solar subcell (D1, D2, D, E) adjacent to said third solar subcell (C1, C2) and composed of a semiconductor material having a fourth band gap smaller than the third band gap and being lattice matched with the third solar subcell (C1, C2), and including a first contact on the top surface thereof, and a second contact on the bottom surface thereof;
(b) partially etching the semiconductor body from the substrate side to form a channel (670) that bisects the fourth solar subcell of the semiconductor body (500), and several ledges or platforms are formed on intermediate layers so that electrical contacts can be made thereto;
(c) forming electrical connections so that the top contact region of the first semiconductor region (698) is electrically coupled with the top contact of the second semiconductor region (699); the first contact region on the top surface of the fourth solar subcell (D1, D) of the first semiconductor region (698) is electrically coupled with the first contact region on the top surface of the fourth solar subcell (D2, E) of the second semiconductor region (699); and the second contact region on the bottom surface of the fourth solar subcell (D1, D) of the first semiconductor region (698) is electrically coupled with the first contact region on the top surface of the fourth solar subcell (D2, E) of the second semiconductor region (699) thereof;
wherein the semiconductor body further comprises a first highly doped lateral conduction layer (603a, 603b) disposed adjacent to and above the fourth solar subcell (D1, D2, D, E) and a blocking p-n diode or insulating layer (604a, 604b) disposed adjacent to and above the first highly doped lateral conduction layer, wherein the first and second semiconductor regions (698, 699) further comprise a second highly doped lateral conduction layer (605b) disposed adjacent to and above the blocking p-n diode or insulating layer (604a, 604b);
and wherein the value of the short circuit current of the fourth subcell (D1, D2, D, E) is at least twice that of the solar subcells (A1, B1, C1, A2, B2, C2) in each parallel stack which are connected in series with the fourth subcell (D1, D2, D, E).

## Patentansprüche

1. Mehrfachsolarzelle mit einem Anschluss einer ersten Polarität (695) und einem Anschluss einer zweiten Polarität (693), enthaltend einen Halbleiterkörper (500), der einschließt:
(a) einen ersten Halbleiterbereich (698), der einschließt:
eine obere erste Solar-Teilzelle (A1), die aus einem Halbleitermaterial mit einer ersten Bandlücke zusammensetzt ist und einen oberen Kontakt auf der oberen Oberfläche davon einschließt;
eine zweite Solar-Teilzelle (B1), die angrenzend zu der ersten Solar-Teilzelle (A1) und aus einem Halbleitermaterial mit einer zweiten Bandlücke kleiner als die erste Bandlücke zusammengesetzt ist und die an die obere erste Solar-Teilzelle (A1) gitterangepasst ist;
eine dritte Solar-Teilzelle (C1), die angrenzend zu der zweiten Solar-Teilzelle (B1) und aus einem Halbleitermaterial mit einer dritten Bandlücke kleiner als die zweite Bandlücke zusammengesetzt ist und die an die zweite Solar-Teilzelle (B1) gitterangepasst ist;
eine vierte Solar-Teilzelle (D1, D), die angrenzend zu der dritten Solar-Teilzelle (C1) und aus einem Halbleitermaterial mit einer vierten Bandlücke kleiner als die dritte Bandlücke zusammengesetzt ist und die an die dritte Solar-Teilzelle (C1) gitterangepasst ist und die einen ersten Kontakt auf der oberen Oberfläche davon und einen zweiten Kontakt auf der unteren Oberfläche davon einschließt;
(b) einen zweiten Halbleiterbereich (699) der angrenzend und parallel zu dem ersten Halbleiterbereich (698) angeordnet ist und einschließt:
eine obere erste Solar-Teilzelle (A2), die aus einem Halbleitermaterial mit einer ersten Bandlücke zusammengesetzt ist und einen oberen Kontakt auf oberen Oberfläche davon einschließt;
eine zweite Solar-Teilzelle (B2), die angrenzend zu der ersten Solar-Teilzelle (A2) und aus einem Halbleitermaterial mit einer zweiten Bandlücke kleiner als die erste Bandlücke zusammengesetzt ist und die an die obere erste Solar-Teilzelle (A2) gitterangepasst ist;
eine dritte Solar-Teilzelle (C2), die angrenzend zu der zweiten Solar-Teilzelle (B2) und aus einem Halbleitermaterial mit einer dritten Bandlücke kleiner als die zweite Bandlücke zusammengesetzt ist und die an die zweiten Solar-Teilzelle (B2) gitterangepasst ist und einen unteren Kontakt aufweist;
eine vierte Solar-Teilzelle (D2, E), die angrenzend zu der dritten Solar-Teilzelle (C2) und aus einem Halbleitermaterial mit einer vierten Bandlücke kleiner als die dritte Bandlücke zusammengesetzt ist und die an die dritte Solar-Teilzelle (C2) gitterangepasst ist und die einen ersten Kontakt auf der oberen Oberfläche davon und einen zweiten Kontakt auf der unteren Oberfläche davon einschließt, der mit dem Anschluss einer zweiten Polarität verbunden ist;
(c) wobei der obere Kontakt des ersten Halbleiterbereichs (698) mit dem oberen Kontakt des zweiten Halbleiterbereichs (699) und mit einem Anschluss der ersten Polarität (695) elektrisch gekoppelt ist;
wobei
der erste Kontakt auf der oberen Oberfläche der vierten Solar-Teilzelle (D1, D) des ersten Halbleiterbereichs (698) mit dem unteren Kontakt der dritten Solar-Teilzelle (C2) des zweiten Halbleiterbereichs (699) elektrisch gekoppelt ist;
der zweite Kontakt auf der unteren Oberfläche der vierten Solar-Teilzelle (D1, D) des ersten Halbleiterbereichs (698) mit dem ersten Kontakt auf der oberen Oberfläche der vierten Solar-Teilzelle (D2, E) des zweiten Halbleiterbereichs (699) davon elektrisch gekoppelt ist, um eine Fünffach-Solarzelle zu bilden;
der Halbleiterkörper ferner eine erste hochdotierte laterale Leitungsschicht (603a, 603b), die angrenzend zu und über der vierten Solar-Teilzelle (D1, D2, D, E) angeordnet ist, und eine p-n-Sperr-Diode oder Isolierschicht (604a, 604b) enthält, die angrenzend zu und über der ersten hochdotierten lateralen Leitungsschicht angeordnet ist, und der erste und zweite Halbleiterbereich (698, 699) ferner eine zweite hochdotierte laterale Leitungsschicht (605b) enthalten, die angrenzend zu und über der p-n-Sperr-Diode oder Isolierschicht (604a, 604b) angeordnet ist;
der Wert des Kurzschlussstroms der vierten Teilzelle (D1, D2, D, E) mindestens doppelt so hoch ist wie der der Solar-Teilzellen (A1, B1, C1, A2, B2, C2) in jedem parallelen Stapel, die mit der vierten Teilzelle (D1, D2, D, E) in Reihe geschaltet sind; und
der Halbleiterkörper teilweise von der Rückseite geätzt ist, um einen Kanal (670) zu bilden, der die vierte Solar-Teilzelle des Halbleiterkörpers (500) halbiert, und mehrere Vorsprünge oder Plattformen auf Zwischenschichten gebildet sind, so dass elektrische Kontakte dazu hergestellt werden können.

2. Mehrfachsolarzelle gemäß Anspruch 1, wobei die vierte Teilzelle eine Bandlücke von etwa 0,67 eV aufweist, die dritte Teilzelle eine Bandlücke im Bereich von etwa 1,41 eV bis 1,31 eV aufweist, die zweite Teilzelle eine Bandlücke im Bereich von etwa 1,65 bis 1,8 eV aufweist und die obere erste Teilzelle eine Bandlücke im Bereich von 2,0 bis 2,20 eV aufweist.

3. Mehrfachsolarzelle gemäß Anspruch 2, wobei die dritte Teilzelle eine Bandlücke von etwa 1,37 eV aufweist, die zweite Teilzelle eine Bandlücke von etwa 1,73 eV aufweist und die obere erste Teilzelle eine Bandlücke von etwa 2,10 eV aufweist.

4. Mehrfachsolarzelle gemäß Anspruch 1, wobei:
die obere erste Teilzelle aus Indiumgalliumaluminiumphosphid zusammengesetzt ist;
die zweite Solar-Teilzelle eine Emitterschicht aus Indiumgalliumphosphid oder Aluminiumgalliumarsenid und eine Basisschicht aus Aluminiumgalliumarsenid oder Indiumgalliumarsenidphosphid einschließt;
die dritte Solar-Teilzelle aus Indiumgalliumarsenid zusammengesetzt ist; und
die vierte Teilzelle aus Germanium zusammengesetzt ist.

5. Mehrfachsolarzelle gemäß Anspruch 1, ferner enthaltend:
eine Distributed-Bragg-Reflektor (DBR)-Schicht angrenzend zu und zwischen den dritten und vierten Solar-Teilzellen und die angeordnet ist, so dass Licht in die dritte Solar-Teilzelle eintreten und durchgehen kann und mindestens ein Teil davon durch die DBR-Schicht in die dritte Solar-Teilzelle zurückreflektiert werden kann, und die Distributed-Bragg-Reflektor-Schicht ist aus einer Vielzahl von alternierenden Schichten aus gitterangepassten Materialien mit Diskontinuitäten in ihren jeweiligen Brechungsindizes zusammengesetzt und die Differenz in den Brechungsindizes zwischen alternierenden Schichten ist maximiert, um die Anzahl der Perioden zu minimieren, die erforderlich sind, um eine gegebene Reflektivität zu erreichen, und die Dicke und der Brechungsindex jeder Periode bestimmen das Stoppband und seine Grenzwellenlänge, und wobei die DBR-Schicht eine erste DBR-Schicht, die aus einer Vielzahl an p-Typ AlₓGa₁₋ₓ(In)As-Schichten zusammengesetzt ist, und eine zweite DBR-Schicht einschließt, die über der ersten DBR-Schicht angeordnet ist und aus einer Vielzahl an n-Typ oder p-Typ Al_{y}Ga_{1-y}(In)As-Schichten zusammengesetzt ist, wobei 0 < x < 1, 0 < y < 1 und y größer als x ist, und (In) bezeichnet, dass Indium ein optionaler Bestandteil ist.

6. Mehrfachsolarzelle gemäß Anspruch 1, wobei die Menge an Aluminium in der oberen ersten Teilzelle mindestens 10 % Molanteil beträgt.

7. Mehrfachsolarzelle gemäß Anspruch 4, wobei die Kurzschlussstromdichte (J_{sc}) der ersten, zweiten und dritten mittleren Teilzellen ungefähr 11 mA/cm² und die Kurzschlussstromdichte (J_{sc}) der unteren Teilzelle ungefähr 22 mA/cm² beträgt.

8. Mehrfachsolarzelle gemäß Anspruch 1, wobei die Kurzschlussdichte (J_{sc}) der unteren Teilzelle mindestens dreimal so groß ist wie die der ersten, zweiten und dritten Teilzellen, wobei der Basisbereich einer solchen Teilzelle eine Abstufung in der Dotierung aufweist, die von der Basis-Emitter-Verbindung zum Boden des Basisbereichs im Bereich von 1 × 10¹⁵ bis 5 × 10¹⁸ pro Kubikzentimeter zunimmt.

9. Mehrfachsolarzelle gemäß Anspruch 1, enthaltend:
eine erste Öffnung in dem ersten Halbleiterbereich (698), die sich von einer unteren Oberfläche des Halbleiterkörpers (500) zu der ersten lateralen Leitungsschicht (604A) erstreckt;
eine zweite Öffnung in dem ersten Halbleiterbereich (698), die sich von der unteren Oberfläche des Halbleiterkörpers (500) bis zur zweiten lateralen Leitungsschicht (603a) erstreckt, und
eine dritte Öffnung in dem ersten Halbleiterbereich (698), die sich von der unteren Oberfläche des ersten Halbleiterkörpers (500) zu dem p-Typ-Halbleitermaterial (600a) der unteren Teilzelle (D1) erstreckt.

10. Mehrfachsolarzelle gemäß Anspruch 9, ferner enthaltend:
ein erstes metallisches Kontaktpad (680), das auf der ersten lateralen Leitungsschicht (605b) jedes der ersten und zweiten Halbleiterbereiche angeordnet ist; und
ein zweites metallisches Kontaktpad (681), das auf der zweiten lateralen Leitungsschicht (603a) des ersten Halbleiterbereichs angeordnet ist;
eine elektrische Verbindung (690), die das erste und zweite Kontaktpad (680, 681) verbindet, ein drittes metallisches Kontaktpad (682), das auf der zweiten lateralen Leitungsschicht (603b) des zweiten Halbleiterbereichs angeordnet ist;
ein viertes metallisches Kontaktpad (683), das auf dem p-Typ-Halbleitermaterial (600a) der unteren Teilzelle (D1) des ersten Halbleiterbereichs angeordnet ist; und
eine elektrische Verbindung (691), die das dritte und vierte Kontaktpad (682, 683) verbindet.

11. Verfahren zur Herstellung einer Mehrfachsolarzelle, enthaltend:
(a) Wachsen einer Sequenz von Halbleiterschichten auf einem Substrat, einen Halbleiterkörper (500) mit einem ersten Halbleiterbereich (698) und einem zweiten Halbleiterbereich (699) bildend, wobei die Sequenz von Schichten einschließt:
eine obere erste Solar-Teilzelle (A1, A2), die aus einem Halbleitermaterial mit einer ersten Bandlücke zusammengesetzt ist und einen oberen Kontaktbereich auf der oberen Oberfläche davon umfasst;
eine zweite Solar-Teilzelle (B1. B2), die angrenzend zu der ersten Solar-Teilzelle (A1, A2) und aus einem Halbleitermaterial mit einer zweiten Bandlücke kleiner als die erste Bandlücke zusammengesetzt ist und die an die obere erste Solar-Teilzelle (A1, A2) gitterangepasst ist;
eine dritte Solar-Teilzelle (C1, C2), die angrenzend zu der zweiten Solar-Teilzelle (B1, B2) und aus einem Halbleitermaterial mit einer dritten Bandlücke kleiner als die zweite Bandlücke zusammengesetzt ist und die an die zweite Solar-Teilzelle (B1, B2) gitterangepasst ist; und
eine vierte Solar-Teilzelle (D1, D2, D, E), die angrenzend zu der dritten Solar-Teilzelle (C1, C2) und aus einem Halbleitermaterial mit einer vierten Bandlücke kleiner als die dritte Bandlücke zusammengesetzt ist und die an die dritte Solar-Teilzelle (C1, C2) gitterangepasst ist und die einen ersten Kontakt auf der oberen Oberfläche und einen zweiten Kontakt auf der unteren Oberfläche davon einschließt;
(b) teilweises Ätzen des Halbleiterkörpers von der Substratseite, um einen Kanal (670) zu bilden, der die vierte Solar-Teilzelle des Halbleiterkörpers (500) halbiert, und mehrere Vorsprünge oder Plattformen werden auf Zwischenschichten gebildet, so dass elektrische Kontakte dazu hergestellt werden können;
(c) Bilden elektrischer Verbindungen, so dass der obere Kontaktbereich des ersten Halbleiterbereichs (698) mit dem oberen Kontakt des zweiten Halbleiterbereichs (699) elektrisch gekoppelt ist; der erste Kontaktbereich auf der oberen Oberfläche der vierten Solar-Teilzelle (D1, D) des ersten Halbleiterbereichs (698) mit dem ersten Kontaktbereich auf der oberen Oberfläche der vierten Solar-Teilzelle (D2, E) des zweiten Halbleiterbereichs (699) elektrisch gekoppelt ist; und der zweite Kontaktbereich auf der unteren Oberfläche der vierten Solar-Teilzelle (D1, D) des ersten Halbleiterbereichs (698) mit dem ersten Kontaktbereich auf der oberen Oberfläche der vierten Solar-Teilzelle (D2, E) des zweiten Halbleiterbereichs (699) elektrisch gekoppelt ist;
wobei der Halbleiterkörper ferner eine erste hochdotierte laterale Leitungsschicht (603a, 603b), die angrenzend zu und über der vierten Solar-Teilzelle (D1, D2, D, E) angeordnet ist, und eine p-n-Sperr-Diode oder Isolierschicht (604a, 604b) enthält, die angrenzend zu und über der ersten hochdotierten lateralen Leitungsschicht angeordnet ist, wobei der erste und zweite Halbleiterbereich (698, 699) ferner eine zweite hochdotierte laterale Leitungsschicht (605b) enthalten, die angrenzend zu und über der p-n-Sperr-Diode oder Isolierschicht (604a, 604b) angeordnet ist;
und wobei der Wert des Kurzschlussstroms der vierten Teilzelle (D1, D2, D, E) mindestens doppelt so hoch ist wie der der Solar-Teilzellen (A1, A2, B1, B2, C1, C2) in jedem parallelen Stapel, die mit der vierten Teilzelle (D1, D2, D, E) in Reihe geschaltet sind.

## Revendications

1. Une cellule solaire à jonctions multiples ayant une borne d'une première polarité (695) et une borne d'une seconde polarité (693) comprenant un corps semi-conducteur (500) comprenant :
(a) une première région semi-conductrice (698) incluant :
une première sous-cellule solaire supérieure (A1) composée d'un matériau semi-conducteur ayant une première bande interdite, et incluant un contact supérieur sur la surface supérieure de celle-ci ;
une seconde sous-cellule solaire (B1) adjacente à ladite première sous-cellule solaire (A1) et composée d'un matériau semi-conducteur ayant une seconde bande interdite plus petite que la première bande interdite et étant appariée en réseau à la première sous-cellule solaire supérieure (A1) ;
une troisième sous-cellule solaire (C1) adjacente à ladite seconde sous-cellule solaire (B1) et composée d'un matériau semi-conducteur ayant une troisième bande interdite plus petite que la seconde bande interdite et étant appariée en réseau à la seconde sous-cellule solaire (B1) ;
une quatrième sous-cellule solaire (D1, D) adjacente à ladite troisième sous-cellule solaire (C1) et composée d'un matériau semi-conducteur ayant une quatrième bande interdite plus petite que la troisième bande interdite et étant appariée en réseau à la troisième sous-cellule solaire (C1), et incluant un premier contact sur la surface supérieure de celle-ci, et un second contact sur la surface inférieure de celle-ci ;
(b) une seconde région semi-conductrice (699) disposée adjacente et parallèle à la première région semi-conductrice (698) et incluant :
une première sous-cellule solaire supérieure (A2) composée d'un matériau semi-conducteur ayant une première bande interdite et incluant un contact supérieur sur la surface supérieure de celle-ci ;
une seconde sous-cellule solaire (B2) adjacente à ladite première sous-cellule solaire (A2) et composée d'un matériau semi-conducteur ayant une seconde bande interdite plus petite que la première bande interdite et étant appariée en réseau à la première sous-cellule solaire supérieure (A2) ;
une troisième sous-cellule solaire (C2) adjacente à ladite seconde sous-cellule solaire (B2) et composée d'un matériau semi-conducteur ayant une troisième bande interdite plus petite que la seconde bande interdite et étant appariée en réseau à la seconde sous-cellule solaire (B2) et ayant un contact inférieur ;
une quatrième sous-cellule solaire (D2, E) adjacente à ladite troisième sous-cellule solaire (C2) et composée d'un matériau semi-conducteur ayant une quatrième bande interdite plus petite que la troisième bande interdite et étant appariée en réseau à la troisième sous-cellule solaire (C2), et incluant un premier contact sur la surface supérieure de celle-ci, et un second contact sur la surface inférieure de celle-ci reliée à la borne d'une seconde polarité ;
(c) dans laquelle le contact supérieur de la première région semi-conductrice (698) est couplé électriquement avec le contact supérieur de la seconde région semi-conductrice (699) et à une borne de première polarité (695) ;
dans laquelle
le premier contact sur la surface supérieure de la quatrième sous-cellule solaire (D1, D) de la première région semi-conductrice (698) est couplé électriquement avec le contact inférieur de la troisième sous-cellule solaire (C2) de la seconde région semi-conductrice (699) ;
le second contact sur la surface inférieure de la quatrième sous-cellule solaire (D1, D) de la première région semi-conductrice (698) est couplé électriquement avec le premier contact sur la surface supérieure de la quatrième sous-cellule solaire (D2, E) de la seconde région semi-conductrice (699) de celle-ci de manière à former une cellule solaire à cinq jonctions;
le corps semi-conducteur comprend en outre une première couche de conduction latérale fortement dopée (603a, 603b) disposée adjacente et au-dessus de la quatrième sous-cellule solaire (D1, D2, D, E) et une p-n diode de blocage ou couche isolante (604a, 604b) disposée adjacente et au-dessus de la première couche de conduction latérale fortement dopée, et les première et seconde régions semi-conductrices (698, 699) comprennent en outre une seconde couche de conduction latérale fortement dopée (605b) disposée adjacente et au-dessus de la p-n diode de blocage ou de la couche isolante (604a, 604b) ;
la valeur du courant de court-circuit de la quatrième sous-cellule (D1, D2, D, E) est au moins deux fois supérieure à celle des sous-cellules solaires (A1, B1, C1, A2, B2, C2) de chaque pile parallèle qui sont connectées en série à la quatrième sous-cellule (D1, D2, D, E) ; et
le corps semi-conducteur est partiellement gravé à partir de l'arrière pour former un canal (670) qui divise la quatrième sous-cellule solaire du corps semi-conducteur (500), et plusieurs saillies ou plates-formes sont formées sur des couches intermédiaires afin que le contact électrique puisse y être établi.

2. La cellule solaire à jonctions multiples selon la revendication 1, dans laquelle la quatrième sous-cellule a une bande interdite d'environ 0,67 eV, la troisième sous-cellule a une bande interdite dans la gamme d'environ 1,41 eV à 1,31 eV, la seconde sous-cellule a une bande interdite dans la gamme d'environ 1,65 à 1,8 eV et la première sous-cellule supérieure a une bande interdite dans la gamme de 2,0 et 2,20 eV.

3. La cellule solaire à jonctions multiples selon la revendication 2, dans laquelle la troisième sous-cellule a une bande interdite d'environ 1,37 eV, la seconde sous-cellule a une bande interdite d'environ 1,73 eV et la première sous-cellule supérieure a une bande interdite d'environ 2,10 eV.

4. La cellule solaire à jonctions multiples selon la revendication 1, dans laquelle la première sous-cellule supérieure est composée de phosphure d'indiumgallium et d'aluminium;
la seconde sous-cellule solaire inclut une couche émettrice composée de phosphure d'indium-gallium ou d'arséniure d'aluminium-gallium, et une couche de base composée d'arséniure d'aluminium-gallium ou de phosphure d'arséniure d'indium-gallium;
la troisième sous-cellule solaire est composée d'arséniure d'indium-gallium; et
la quatrième sous-cellule est composée de germanium.

5. La cellule solaire à jonctions multiples selon la revendication 1, comprenant en outre :
une couche de réflecteur de Bragg distribuée (DBR) adjacente à et entre les troisième et quatrième sous-cellules solaires et disposée de manière à ce que la lumière puisse entrer et traverser la troisième sous-cellule solaire et dont au moins une partie puisse être réfléchie dans la troisième sous-cellule solaire par la couche DBR, et la couche réflecteur de Bragg distribuée est composée d'une pluralité de couches alternées de matériaux appariés en réseau avec des discontinuités dans leurs indices respectifs de réfraction et la différence d'indices de réfraction entre couches alternées est maximisée afin de minimiser le nombre de périodes nécessaires pour atteindre une réflectivité donnée, et l'épaisseur et l'indice de réfraction de chaque période déterminent la bande d'arrêt et sa longueur d'onde limite, et dans laquelle la couche DBR comprend une première couche DBR composée d'une pluralité de couches de type p de AlₓGa₁₋ₓ(In)As et une seconde couche DBR disposée sur la première couche DBR et composée d'une pluralité de couches de type n ou p de Al_{y}Ga_{1-y}(In)As, où 0 < x < 1, 0 < y < 1, et y est supérieur à x, et (In) désigne que l'indium est un constituant facultatif.

6. La cellule solaire à jonctions multiples selon la revendication 1, dans laquelle la quantité d'aluminium dans la première sous-cellule supérieure est d'au moins 10% par fraction molaire.

7. La cellule solaire à jonctions multiples selon la revendication 4, dans laquelle la densité de courant de court-circuit (J_{sc}) des premier, seconde et troisième sous-cellules centrales est d'environ 11 mA/cm², et la densité de courant de court-circuit (J_{sc}) de la sous-cellule inférieure est d'environ 22 mA/cm².

8. La cellule solaire à jonctions multiples selon la revendication 1, dans laquelle la densité de court-circuit (J_{sc}) de la sous-cellule inférieure est au moins trois fois supérieure à celle des première, secondes et troisième sous-cellules, dans laquelle la région de base de cette sous-cellule ayant une gradation en dopage qui augmente de la jonction base-émetteur au bas de la région de base dans la gamme de 1 × 10¹⁵ à 5 × 10¹⁸ par centimètre cube.

9. La cellule solaire à jonctions multiples selon la revendication 1 comprenant :
une première ouverture dans la première région semi-conductrice (698) s'étendant d'une surface inférieure du corps semi-conducteur (500) à la première couche de conduction latérale (604a) ;
une seconde ouverture dans la première région semi-conductrice (698) s'étendant de la surface inférieure du corps semi-conducteur (500) à la seconde couche de conduction latérale (603a) ; et
une troisième ouverture dans la première région semi-conductrice (698) s'étendant de la surface inférieure du premier corps semi-conducteur (500) au matériau semi-conducteur de type p (600a) de la sous-cellule inférieure (D1).

10. La cellule solaire à jonctions multiples selon la revendication 9, comprenant en outre :
une première couche de contact métallique (680) disposée sur la première couche de conduction latérale (605b) de chacune des première et seconde régions semi-conductrices ; et
une seconde couche de contact métallique (681) disposée sur la seconde couche de conduction latérale (603a) de la première région semi-conductrice ;
une interconnexion électrique (690) reliant les première et seconde couches de contact (680, 681), une troisième couche de contact métallique (682) disposée sur la seconde couche de conduction latérale (603b) de la seconde région semi-conductrice ;
une quatrième couche de contact métallique (683) disposée sur le matériau semi-conducteur de type p (600a) de la sous-cellule inférieure (D1) de la première région semi-conductrice ; et
une interconnexion électrique (691) reliant les troisième et quatrième couches de contact (682, 683).

11. Un procédé de fabrication d'une cellule solaire à jonctions multiples comprenant :
(a) croître une séquence de couches semi-conductrices sur un substrat formant un corps semi-conducteur (500) avec une première région semi-conductrice (698) et une seconde région semi-conductrice (699), la séquence de couches comprenant :
une première sous-cellule solaire supérieure (A1, A2) composée d'un matériau semi-conducteur ayant une première bande interdite et incluant une région de contact supérieure sur la surface supérieure de celle-ci;
une seconde sous-cellule solaire (B1, B2) adjacente à ladite première sous-cellule solaire (A1, A2) et composée d'un matériau semi-conducteur ayant une seconde bande interdite plus petite que la première bande interdite et étant appariée en réseau à la première sous-cellule solaire supérieure (A1, A2);
une troisième sous-cellule solaire (C1, C2) adjacente à ladite seconde sous-cellule solaire (B1, B2) et composée d'un matériau semi-conducteur ayant une troisième bande interdite plus petite que la seconde bande interdite et étant appariée en réseau à la seconde sous-cellule solaire (B1, B2); et
une quatrième sous-cellule solaire (D1, D2, D, E) adjacente à ladite troisième sous-cellule solaire (C1, C2) et composée d'un matériau semi-conducteur ayant une quatrième bande interdite plus petite que la troisième bande interdite et étant appariée en réseau à la troisième sous-cellule solaire (C1, C2), et incluant un premier contact sur la surface supérieure de celle-ci, et un second contact sur la surface inférieure de celle-ci ;
(b) graver partiellement le corps semi-conducteur du côté du substrat pour former un canal (670) qui divise la quatrième sous-cellule solaire du corps semi-conducteur (500), et plusieurs saillies ou plates sont formées sur des couches intermédiaires afin que le contact électrique puisse y être établi ;
(c) former des connexions électriques de telle sorte que la région de contact supérieure de la première région semi-conductrice (698) soit couplée électriquement avec le contact supérieur de la seconde région semi-conductrice (699) ; la première région de contact sur la surface supérieure de la quatrième sous-cellule solaire (D1, D) de la première région semi-conductrice (698) soit couplée électriquement avec la première région de contact sur la surface supérieure de la quatrième sous-cellule solaire (D2, E) de la seconde région semi-conductrice (699); et la seconde région de contact sur la surface inférieure de la quatrième sous-cellule solaire (D1, D) de la première région semi-conductrice (698) soit couplée électriquement avec la première région de contact sur la surface supérieure de la quatrième sous-cellule solaire (D2, E) de la seconde région semi-conductrice (699) de celle-ci ;
dans laquelle le corps semi-conducteur comprend en outre une première couche de conduction latérale fortement dopée (603a, 603b) disposée adjacente et au-dessus de la quatrième sous-cellule solaire (D1, D2, D, E) et une p-n diode de blocage ou une couche isolante (604a, 604b) disposée adjacente et au-dessus de la première couche de conduction latérale fortement dopée, dans laquelle les première et seconde régions semi-conductrices (698, 699) comprennent en outre une seconde couche de conduction latérale fortement dopée (605b) disposée adjacente et au-dessus de la p-n diode de blocage ou de la couche isolante (604a, 604b) ;
et dans laquelle la valeur du courant de court-circuit de la quatrième sous-cellule (D1, D2, D, E) est au moins deux fois celle des sous-cellules solaires (A1, B1, C1, A2, B2, C2) de chaque pile parallèle qui sont connectées en série à la quatrième sous-cellule (D1, D2, D, E).
